# EUROPEAN PATENT APPLICATION

(11) **EP 3 382 291 A1**
(43) Date of publication of application: **03.10.2018**
(21) Application number: 18165074.8
(22) Date of filing: 29.03.2018
(51) Int. Cl.: F24F 1/24, H01L 23/40, H05K 1/02

(54) **REFRIGERATING APPARATUS, COMPOSITE PIPE, AND METHOD FOR ASSEMBLING COOLING BODY**

(30) Priority: 31.03.2017 JP 2017070000
(71) Applicant: MITSUBISHI HEAVY INDUSTRIES THERMAL SYSTEMS, LTD., Tokyo 108-8215 (JP)
(72) Inventor: OISHI, Tsuyoshi, TOKYO, 108-8215 (JP); TAKEUCHI, Nobuyuki, TOKYO, 108-8215 (JP); MURAKAMI, Kenichi, TOKYO, 108-8215 (JP)
(74) Representative: Cabinet Beau de Loménie

(57) **Abstract**

The refrigerating apparatus includes a casing having a board accommodating portion (14) therein; a circuit board (21) on which a heat generation component (25) is mounted on a back surface (21b), the circuit board being attached to the board accommodating portion (14) with a front surface (21a) facing the front side when the casing is installed; a refrigerant pipe (10) disposed on a back surface (21b) side of the circuit board (21); and a cooling body (26) disposed on the back surface (21b) side of the circuit board (21) to come into contact with the refrigerant pipe (10) and the heat generation component (25). The cooling body (26) has a first member (26a) attached to the refrigerant pipe (10), a second member (26b) attached to the heat generation component (25), and an attachment and detachment screw (31) capable of attaching and detaching the second member (26b) to and from the first member (26a) at the front surface (21a) side of the circuit board (21).

## Description

### BACKGROUND OF THE INVENTION

### Field of the Invention

The present invention relates to a refrigerating apparatus, a composite pipe, and a method for assembling a cooling body.

### Description of Related Art

From related art, in a refrigerating apparatus, an apparatus for cooling a board unit in which a heat generation component is mounted on a circuit board using a refrigerant is known.

For example, Patent Document 1 discloses a refrigerating apparatus in which a heat generation component of a board unit and a refrigerant pipe are attached to a cooler and the heat generation component of the board unit is cooled using a refrigerant. In the refrigerating apparatus, the cooler attached to the refrigerant pipe and the heat generation component is attached to the board via a support member.

### [Patent Documents]

[Patent Document 1] Japanese Unexamined Patent Application, First Publication No. 2013-242132

However, for example, when the cooler attached to the refrigerant pipe and the heat generation component as described above is attached to a front surface side of the board provided with various kinds of electronic components and circuits, at the time of assembly, a tool or the like may come into contact with the circuit or the electronic components of the board surface and cause damage, resulting in a possibility of manufacturing failure. Further, when a cooler is provided on a back surface side of the board to avoid such damage, work of detaching the cooler from the board becomes difficult, for example, when replacing the board.

Thus, the present invention provides a refrigerating apparatus, a composite pipe, and a method for assembling a cooling body in which it is possible to reduce the likelihood that a tool or the like will come into contact with the circuit, the electronic components or the like of the circuit board and cause damage at the time of assembly, and it is easy to attach and detach or replace the board unit after assembly.

### SUMMARY OF THE INVENTION

A refrigerating apparatus according to a first aspect of the present invention includes: a casing having a board accommodating portion therein; a circuit board on which heat generation components are mounted on a rear surface, the circuit board being attached to the board accommodating portion with a front surface facing a front side when the casing is installed; a refrigerant pipe disposed on a rear surface side of the circuit board; and a cooling body disposed on the rear surface side of the circuit board and coming into contact with the refrigerant pipe and the heat generation components. The cooling body has a first member attached to the refrigerant pipe, a second member attached to the heat generation components, and an attachment and detachment screw allowing attachment and detachment of the second member to and from the first member at the front surface side of the circuit board.

According to the present invention, since the cooling body is disposed on the back surface side of the circuit board, at the time of assembly, it is possible to reduce the likelihood of the tool coming into contact with a circuit, an electronic component, or the like disposed on the front surface of the circuit board and causing damage.

Further, the cooling body is divided into the first member and the second member, and is configured to be attachable to and detachable from the front surface side of the circuit board using the attachment and detachment screw. Therefore, if the attachment and detachment screw is manipulated from the front surface side of the circuit board to separate the first member and the second member, the circuit board can be easily detached from the board accommodating portion. Further, even if the cooling body is disposed on the back surface side of the circuit board and attached to the refrigerant pipe or the heat generation components, it is not necessary to detach the cooling body on the back surface side of the circuit board. This makes it possible to easily attach and detach or exchange the board unit and to improve workability at the time of maintenance and the like.

According to the refrigerating apparatus of a second aspect of the present invention, the first aspect of the refrigerant pipe may have a joining portion having a contact surface extending obliquely in a width direction of the casing with respect to the back surface of the circuit board, and the first member may have a refrigerant pipe attachment surface which is obliquely provided toward the width direction of the casing with respect to the back surface of the circuit board, and an attachment and detachment screw which attaches and detaches the contact surface of the joining portion to and from the refrigerant pipe attachment surface.

According to this configuration, the refrigerant pipe attachment surface of the cooling body is provided obliquely with respect to the circuit board, the joining portion of the refrigerant pipe is disposed obliquely with respect to the circuit board, and the refrigerant pipe attachment surface and the joining portion are attachable and detachable by the refrigerant pipe attachment and detachment screw. Therefore, attachment and detachment of the cooling body and the refrigerant pipe can be performed from the lateral side of the casing which is the end surface of the casing in the width direction rather than from the further rear side of the back surface, on the back surface side of the circuit board. Therefore, it is possible to improve workability at the time of assembly of the cooling body.

A third aspect of the present invention provides an assembly method for assembling the cooling body in the refrigerating apparatus according to the first or second aspect, the assembly method including: attaching the first member and the second member by the attachment and detachment screw to form a cooling body; attaching the heat generation component to the second member; and mounting the heat generation component and the cooling body on the back surface of the circuit board.

According to this configuration, the heat generation component is attached to the second member of the cooling body, and the heat generation component is mounted on the back surface of the circuit board, thereby disposing the cooling body on the back surface side of the circuit board. Therefore, when assembling the cooling body, it is possible to reduce the possibility that the tool is brought into contact with a circuit, an electronic component, or the like disposed on the front surface of the circuit board to cause damage.

Further, the attachment and detachment screw for attaching the second member to the first member to form the cooling body is disposed to be attachable to and detachable from the front surface side of the circuit board, and the heat generation component is mounted on the back surface of the circuit board. Therefore, after assembling the cooling body, by manipulating the attachment and detachment screw from the front surface side of the circuit board, the first member and the second member can be separated and the circuit board can be easily extracted from the board accommodating portion.

According to the assembly method of the fourth aspect of the present invention, the third aspect of the assembly method further includes a process of mounting an electronic component on the front surface of the circuit board on which the heat generation component is mounted.

According to this configuration, since the electronic component is mounted on the front surface of the circuit board after mounting the heat generation component to which the cooling body is attached, it is possible to prevent damage to the electronic component on the front surface of the circuit board when attaching the cooling body to the circuit board.

A fifth aspect of the present invention provides a composite pipe which includes a refrigerant pipe of a refrigerating apparatus; and a cooling body which is in contact with the refrigerant pipe and a heat generation component mounted on a circuit board of the refrigerating apparatus. The cooling body has a first member attached to the refrigerant pipe, a second member attached to the heat generation component, and an attachment and detachment screw capable of attaching and detaching the second member to and from the first member.

According to this configuration, the cooling body is divided into a first member attached to the refrigerant pipe and a second member attached to the heat generation member and is configured to be attachable and detachable by the attachment and detachment screw. Therefore, it is possible to attach and detach the refrigerant pipe and the heat generation member of the circuit board, while attaching the first member to the refrigerant pipe and attaching the second member to the heat generation member on the circuit board by the attachment and detachment screw. As a result, workability can be improved at the time of maintenance or the like.

According to the present invention, it is possible to provide a refrigerating apparatus, a composite pipe, and a method for assembling a cooling body in which it is possible to reduce the possibility that a tool or the like comes into contact with the circuit, the electronic components or the like of the circuit board to cause damage at the time of assembly, and it is easy to attach and detach or replace the board unit after assembly.

### BRIEF DESCRIPTION OF THE DRAWINGS

FIG. 1 is a refrigerant circuit diagram of an air conditioner in an embodiment of the present invention.
FIG. 2 is an exploded perspective view of a controller in the air conditioner according to the embodiment of the present invention as viewed from a front side.
FIG. 3A is an exploded perspective view of the controller of the air conditioner according to the embodiment of the present invention as viewed from a back side.
FIG. 3B is a cross-sectional view taken along the line A-A of FIG. 3A.
FIG. 4 is a cross-sectional view of a main part of the air conditioner according to the embodiment of the present invention.
FIG. 5 is a cross-sectional view for explaining a method for assembling a cooling block of the air conditioner according to the embodiment of the present invention, illustrating a process of forming the cooling block.
FIG. 6 is a cross-sectional view for explaining the method for assembling the cooling block in the air conditioner according to the embodiment of the present invention, illustrating a process of attaching a heat generation component to the cooling block.
FIG. 7 is a cross-sectional view for explaining the method for assembling the cooling block in the air conditioner according to the embodiment of the present invention, illustrating a process of mounting the heat generation component on a board.
FIG. 8 is a cross-sectional view for explaining the method for assembling the cooling block in the air conditioner according to the embodiment of the present invention, and is a cross-sectional view illustrating a process of attaching the board to a board accommodating portion and attaching the cooling block to a refrigerant pipe.
FIG. 9 is a perspective view illustrating the method for assembling the cooling block in the air conditioner according to the embodiment of the present invention, and is a perspective view illustrating a process of attaching the board to the board accommodating portion and attaching the cooling block to the refrigerant pipe.

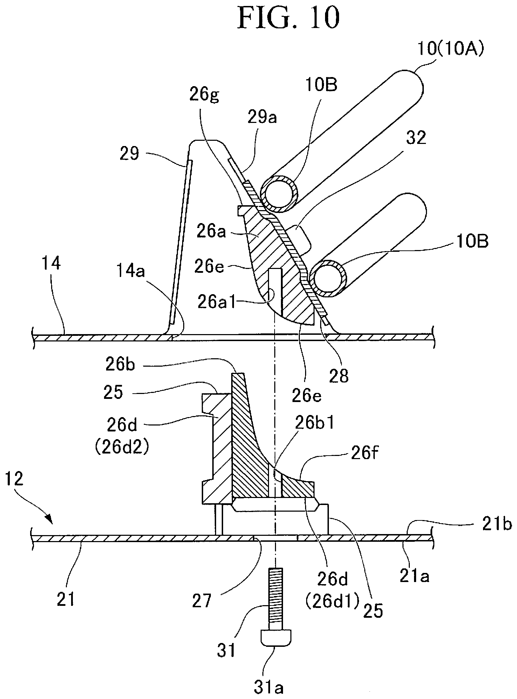

FIG. 10 is a cross-sectional view illustrating a process of replacing a board in the method for assembling the cooling block to the air conditioner according to an embodiment of the present invention.

### DETAILED DESCRIPTION OF THE INVENTION

An air conditioner (refrigerating apparatus) 1 according to an embodiment of the present invention will be described.

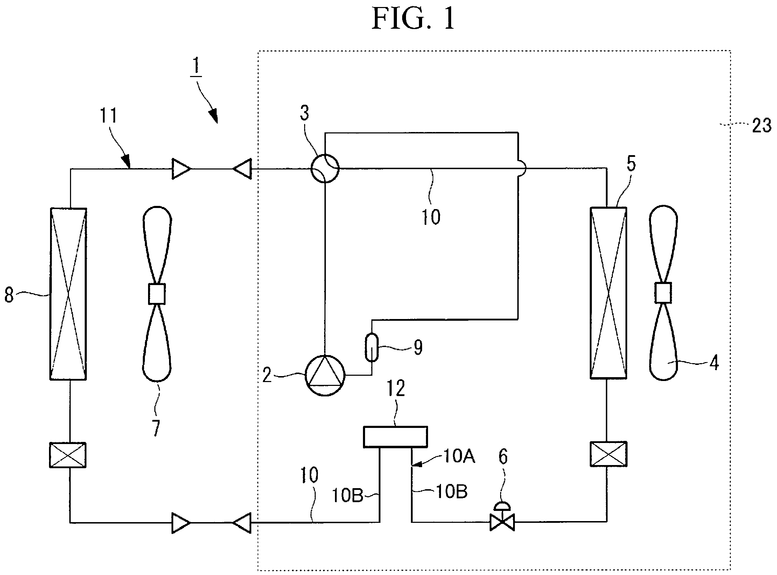

An air conditioner 1 illustrated in FIG. 1 mainly includes a compressor 2, a four-way switching valve 3, an outdoor fan 4, an outdoor heat exchanger 5, an electronic expansion valve (EEV) 6, an indoor fan 7, an indoor heat exchanger 8, and an accumulator 9. These devices are connected by a refrigerant pipe 10 to constitute a refrigeration cycle 11 in a closed cycle. Among these components, the compressor 2, the four-way switching valve 3, the outdoor fan 4, the outdoor heat exchanger 5, the electronic expansion valve (EEV) 6, and the accumulator 9 are accommodated in a casing 23 of the outdoor unit, and the indoor fan 7 and the indoor heat exchanger 8 are accommodated in a casing (not illustrated) of the indoor unit.

The compressor 2 is a device that compresses refrigerant.

The four-way switching valve 3 is a device that switches the circulation direction of the refrigerant.

The outdoor heat exchanger 5 is a device which exchanges heat between the refrigerant and the outside air from the outdoor fan 4.

The electronic expansion valve (EEV) 6 is a device that adiabatically expands the refrigerant.

The indoor heat exchanger 8 is a device which exchanges heat between the refrigerant and the inside air from the indoor fan 7. The accumulator 9 is a device which separates out the liquid phase of the refrigerant that has not evaporated in the evaporator to prevent the liquid phase from flowing into the compressor 2.

Furthermore, the air conditioner 1 further includes a controller 12 that controls the operation of the air conditioner 1 on the basis of an operation command from an operation unit such as a remote controller. The controller 12 is accommodated in the casing 23 of the outdoor unit.

For example, the controller 12 is equipped with an inverter that controls the rotation speed of the compressor 2 and includes functions of switching the four-way switching valve 3 depending on the operation mode, controlling a rotation speed of the outdoor fan 4 and the indoor fan 7, and an opening degree of the electronic expansion valve 6 and the like.

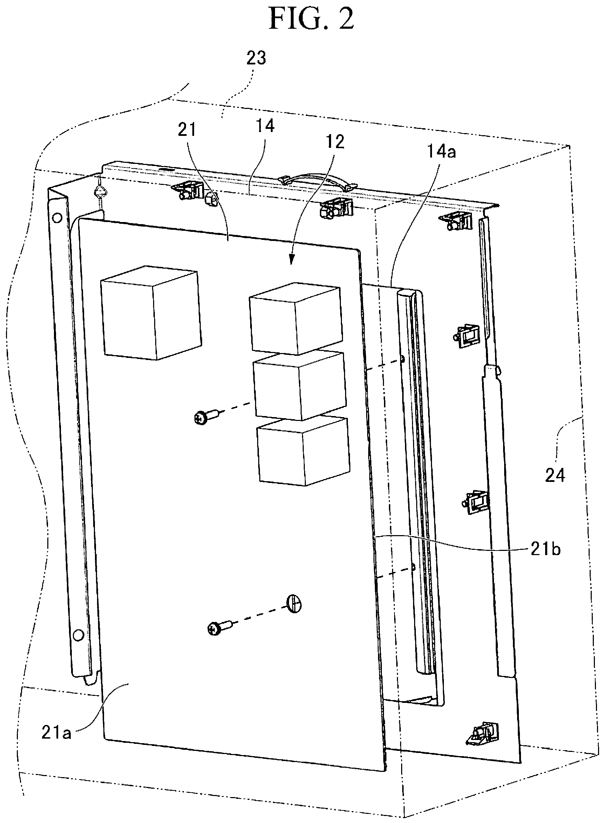

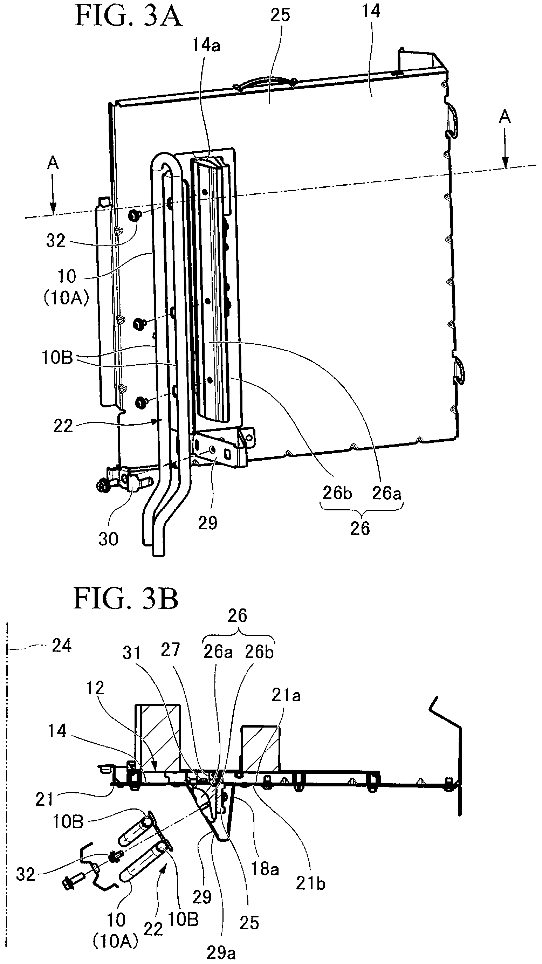

Here, as illustrated in Figs. 2, 3A, and 3B, the casing 23 has a board accommodating portion 14 inside. A controller 12 is attached to the board accommodating portion 14. The board accommodating portion 14 is disposed in the casing 23 of the outdoor unit with an interval between an inner surface on the front side of the casing 23 and an inner surface on the back side. Here, the front side means a front surface side when the outdoor unit is installed, and the back side means a rear surface side when the outdoor unit is installed.

The controller 12 includes a board 21 (circuit board) attached to the board accommodating portion 14. In the present embodiment, a front surface 21a of the board 21 is disposed toward the front side, and a back surface 21b of the board 21 is disposed toward the rear side.

The board 21 includes various electronic components, such as an active converter, a diode module, and a power transistor that constitute an inverter. A part of these various electronic components is mounted on the front surface 21a of the board 21. Further, the heat generation components 25 of the electronic components are mounted on the back surface 21b of the board 21.

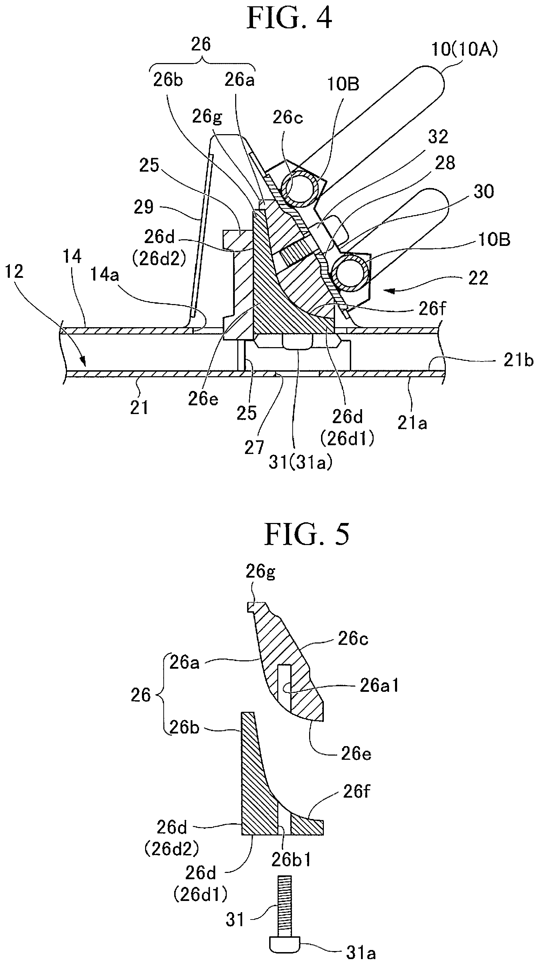

A part 10A of the refrigerant pipe 10 provided between the electronic expansion valve 6 and the indoor heat exchanger 8 is disposed on the back surface 21b side of the board 21 and on the back surface side of the board accommodating portion 14 in the casing 23. In this part 10A, a pair of tubular portions 10B is provided by forming the refrigerant pipe 10 in a U shape. As a result, as illustrated in FIG. 4, the refrigerant pipe 10 has a pair of tubular portions 10B, and a joining portion 28 disposed between the tubular portions 10B to support the tubular portions 10B.

The pair of tubular portions 10B are disposed side by side in an inclined direction with respect to a depth direction (a direction from the front surface to the back surface side) of the casing 23. More specifically, with respect to one tubular portion 10B, the other tubular portion 10B is disposed on the rear side in the casing 23 and on the side close to the side surface 24 which is an end surface in the width direction of the casing 23.

The joining portion 28 is formed of the same material as that of the tubular portions 10B in the form of a plate and is provided obliquely to correspond to the tubular portions 10B along the direction in which the pair of tubular portions 10B is arranged. The pair of tubular portions 10B of the refrigerant pipe 10 are joined to the joining portion 28, respectively, by brazing or the like. Further, the joining portion 28 has a surface (contact surface) protruding toward the tubular portions 10B between the tubular portions 10B, and the protruding portion thereof is fitted between the tubular portions 10B.

The tubular portions 10B of the refrigerant pipe 10 are clamped in a predetermined position and orientation, by an inclined surface 29a of a bracket 29 having a substantially triangular shape in a top view provided to protrude from the board accommodating portion 14 to the back surface side below the joining portion 28, and a clamping piece 30 facing the inclined surface 29a.

Here, in the casing 23, a metal (metal having high heat conductivity such as aluminum) cooling block (cooling body) 26 coming into contact with the pair of tubular portions 10B and the heat generation components 25 of the controller 12 is provided on the back surface 21b side of the board 21.

The cooling block 26 has a first block 26a attached to the refrigerant pipe 10, a second block 26b attached to the heat generation components 25, and a block attachment and detachment screw 31a which allow mounting of the first block 26a and the second block 26b by being brought into contact with each other in a heat-transferable manner.

The first block 26a has a refrigerant pipe attachment surface 26c that is provided obliquely with respect to the back surface 21b of the board 21 and attached to the tubular portions 10B of the refrigerant pipe 10 along the inclined direction of the front surface of the joining portion 28, an opposite abutting surface 26e abutting against the second block 26b, and a refrigerant pipe attachment and detachment screw 32 which attachably and detachably attaches the joining portion 28 to the refrigerant pipe attachment surface 26c.

The refrigerant pipe attachment surface 26c has a shape corresponding to the front surface of the joining portion 28 of the refrigerant pipe 10. That is, the refrigerant pipe attachment surface 26c has a shape that protrudes toward the side surface 24 between the tubular portions 10B.

In this embodiment, the opposite abutting surface 26e has a curved shape that protrudes from the joining portion 28 toward the back surface 21b of the board 21, but may be a simple flat surface, or may be formed in a stepwise shape when viewed from above. Further, a positioning protrusion 26g protruding in the width direction of the casing 23 is provided on the opposite abutting surface 26e. The positioning protrusion 26g is provided at a position close to the end portion of the opposite abutting surface 26e away from the board 21.

The second block 26b has two heat generation component attachment surfaces 26d to which the heat generation components 25 are attached, and an opposite abutting surface 26f which abuts against the opposite abutting surface 26e of the first block 26a.

One (a surface 26d1) of the two heat generation component attachment surfaces 26d faces the back surface 21b of the board 21, and the other (a surface 26d2) faces the width direction of the casing 23. That is, the two heat generation component attachment surfaces 26d are provided in a direction along the board 21 and a direction rising from the board 21. Here, an opening portion 14a is provided in the board accommodating portion 14, and the heat generation component 25 on the back surface 21b of the board 21 protrudes to the back surface side of the board accommodating portion 14 through the opening portion 14a. Further, the heat generation component 25 arranged along the board 21 and mounted on the board 21, and the heat generation component 25 disposed upright from the board 21 and mounted on the board 21 are attached to the heat generation component attachment surfaces 26d, respectively, by mounting screws (not illustrated) or the like.

The opposite abutting surface 26f is formed along the opposite abutting surface 26e. That is, in this embodiment, the opposite abutting surface 26f has a curved shape that is recessed toward the back surface 21b of the board 21. Accordingly, the opposite abutting surface 26f and the opposite abutting surface 26e are in surface contact with each other. When the opposite abutting surface 26f and the opposite abutting surface 26e come into surface contact with each other, the end portion of the second block 26b on the side away from the board 21 abuts against the positioning protrusion 26g.

The block attachment and detachment screw 31 is disposed at a position corresponding to the attaching and detaching through hole 27 penetrating the board 21. A head portion 31a of the block attachment and detachment screw 31 is exposed on the front surface 21a of the board 21. When the block attachment and detachment screw 31 is screwed into the first block 26a through the second block 26b, the second block 26b and the first block 26a are fixed in a state in which the opposite abutting surfaces 26f and 26e are in contact with each other. The head portion 31a is formed to be smaller than the attaching and detaching through hole 27 so that the block attachment and detachment screw 31 can pass through the attaching and detaching through hole 27 of the board 21 from the front surface 21a side of the board 21. As a result, the block attachment and detachment screw 31 can be manipulated from the front surface 21a side of the board 21, and the first block 26a and the second block 26b are attachable and detachable.

Next, an assembly method for assembling the cooling block 26 to the air conditioner 1 will be described.

First, as illustrated in FIG. 5, the second block 26b and the first block 26a are attached to each other using the block attachment and detachment screw 31 and integrated to form the cooling block 26.

The opposite abutting surface 26e of the first block 26a and the opposite abutting surface 26f of the second block 26b are brought into close contact with each other, and the block attachment and detachment screw 31 is passed through the through hole 26b1 of the second block 26b to screw into the screw portion 26a1 of the first block 26a.

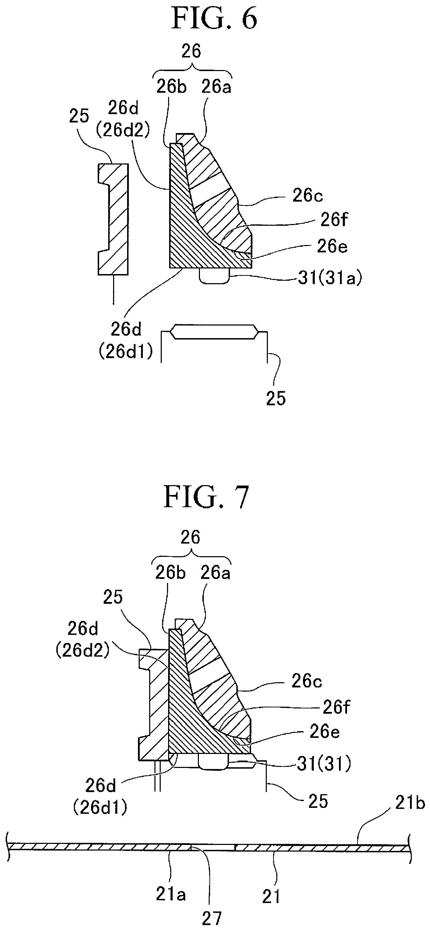

Next, as illustrated in FIG. 6, a plurality of heat generation components 25 is attached to the integrated cooling block 26.

The heat generation components 25 are brought into close contact with and fixed to the plurality of heat generation component attachment surfaces 26d1 and 26d2 provided on the second block 26b of the cooling block 26, for example by mounting screws or the like.

Next, as illustrated in FIG. 7, the heat generation component 25 to which the cooling block 26 is attached is mounted on the back surface 21b of the board 21.

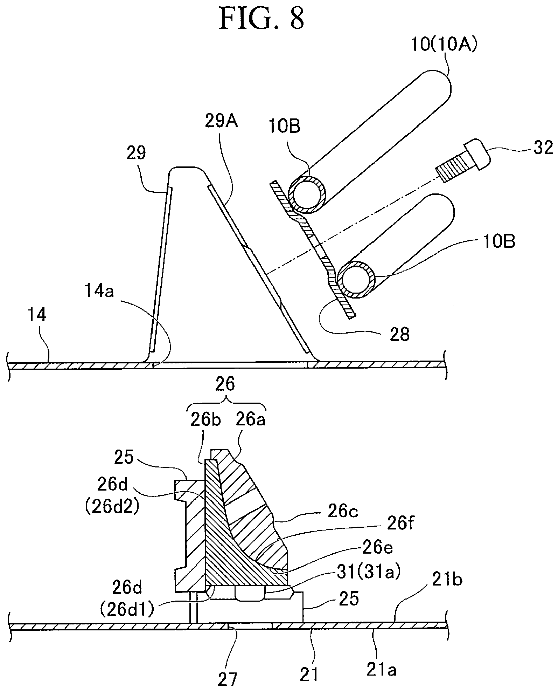

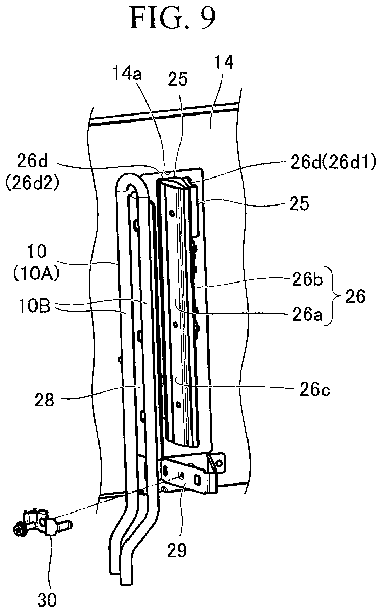

Thereafter, as illustrated in FIGS. 8 and 9, the board 21 is attached to the board accommodating portion 14 and the first block 26a of the cooling block 26 is attached to the refrigerant pipe 10.

That is, the bracket 29 is fixedly disposed on the back surface of the board accommodating portion 14. Further, the back surface 21b of the board 21 is made to face the board accommodating portion 14, the cooling block 26 and the heat generation component 25 are inserted into the opening portion 14a of the board accommodating portion 14, and the board 21 is attached to the board accommodating portion 14. As a result, the first block 26a of the cooling block 26 is disposed so as to be attachable to the refrigerant pipe 10. The refrigerant pipe attachment surface 26c of the first block 26a is brought into close contact with and fixed to the joining portion 28 of the refrigerant pipe 10 by the refrigerant pipe attachment and detachment screw 32.

Next, a procedure in a case of replacing the board 21 in maintenance work of the air conditioner 1 thus obtained will be described.

When replacing the board 21, a panel (not illustrated) of the casing 23 of the outdoor unit is first removed, and the board accommodating portion 14 is opened to open the front surface 21a side of the board 21, thereby exposing the front surface 21a of the board 21 to the outside.

By detaching the mounting screw or the like attaching the board 21 to the board accommodating portion 14 and by inserting a tool into the attaching and detaching through hole 27 of the board 21 to loosen the block attachment and detachment screw 31, the second block 26b is separated from the first block 26a of the cooling block 26.

In this state, the board 21 in a state in which the second block 26b and the heat generation component 25 are mounted is separated from the board accommodating portion 14 on which the first block 26a and the refrigerant pipe 10 are mounted, and the board 21 can be extracted from the casing 23.

Thereafter, a new board 21 in a state in which the second block 26b and the heat generation component 25 are mounted is accommodated in the casing 23. Then, the board 21 is disposed at a predetermined position of the board accommodating portion 14, the tool is inserted from the attaching and detaching through hole 27 of the board 21, the second block 26b is attached to the first block 26a by the block attachment and detachment screw 31, and the board 21 is attached to the board accommodating portion 14 with mounting screws or the like.

Thus, the board 21 can be exchanged.

According to the air conditioner 1 of the present embodiment described above, as illustrated in FIG. 4, the cooling block 26 is attached in a state in which the second block 26b is in close contact with the heat generation component 25 mounted on the back surface 21b of the board 21. Further, the second block 26b is in close contact with and attached to the first block 26a by the block attachment and detachment screw 31. The first block 26a is in close contact with and attached to the joining portion 28 of the refrigerant pipe 10 with the refrigerant pipe attachment and detachment screw 32.

In this state, when heat is generated from the heat generation component 25 of the controller 12, heat is transferred to the refrigerant pipe 10 by the cooling block 26, and heat is further released to the refrigerant flowing through the refrigerant pipe 10. As a result, the heat generation component 25 of the controller 12 can be cooled.

When manufacturing the air conditioner 1, since the cooling block 26 is disposed on the back surface 21b side of the board 21, at the time of assembly, it is possible to reduce the possibility in which the tool comes into contact with the a circuit, an electronic component, or the like disposed on the front surface 21a of the board 21 to cause damage.

Further, the cooling block 26 is divided into the first block 26a and the second block 26b, and is configured to be attachable to and detachable from the front surface 21a side of the board 21 by the block attachment and detachment screw 31. Therefore, at the time of maintenance, if the block attachment and detachment screw 31 is manipulated from the front surface 21a side of the board 21 to separate the first block 26a and the second block 26b, the board 21 can be easily detached from the board accommodating portion 14. At this time, even if the cooling block 26 is disposed on the back surface 21b side of the board 21 and attached to the refrigerant pipe 10 or the heat generation component 25, it is not necessary to detach the cooling block 26 on the back surface 21b side of the board 21. Further, it is not necessary to attach and detach the entire cooling block 26. This makes it possible to easily attach and detach or exchange the board 21 and to improve workability at the time of maintenance and the like.

Further, the refrigerant pipe attachment surface 26c of the cooling block 26 is provided obliquely with respect to the board 21, the joining portion 28 of the refrigerant pipe 10 is disposed obliquely with respect to the board 21, and the refrigerant pipe attachment surface 26c and the joining portion 28 are attachable and detachable by the refrigerant pipe attachment and detachment screw 32. Therefore, attachment and detachment of the cooling block 26 and the refrigerant pipe 10 can be performed from the lateral side of the casing 23 rather than from the rear side of the back surface 21b, on the back surface 21b side of the board 21. Therefore, it is possible to improve workability at the time of assembly of the cooling block.

Further, since the plurality of heat generation component attachment surfaces 26d1 and 26d2 are provided, it is possible to efficiently cool the plurality of heat generation components 25 attached to the plurality of heat generation component attachment surfaces 26d. Moreover, since the cooling block 26 is attached to more heat generation components 25 fixed to the board 21, it is easy to stably dispose the cooling block 26.

The method for assembling the cooling block 26 includes a process of mounting the electronic components on the front surface 21a of the board 21 on which the heat generation component 25 to which the cooling block 26 is attached is mounted. Therefore, since the electronic components are mounted on the front surface 21a of the board 21 after mounting the heat generation component 25 with the cooling block 26 attached thereto, when mounting the cooling block 26 on the board 21, it is possible to reliably prevent the electronic components mounted on the front surface 21a of the board 21 from being damaged.

Although the embodiments of the present invention have been described in detail with reference to the drawings, the specific configuration is not limited to this embodiment, and design changes and the like within the scope not deviating from the gist of the present invention are also included.

In the above embodiment, the example in which the first block 26a is attached to the refrigerant pipe 10 after the heat generation component 25 is mounted on the back surface 21b of the board 21 has been described, but there is no particular limitation thereto. It is also possible to mount the heat generation component 25 on the back surface 21b of the board 21 after attaching the first block 26a to the refrigerant pipe 10 when mounting the heat generation component 25 on the back surface 21b of the board 21.

In the above embodiment, the second block 26b is attached to the first block 26a by the block attachment and detachment screw 31, the second block 26b is attached to the heat generation component 25, and the terminal of the heat generation component 25 is fixed to the board 21. Thus, the cooling block 26 is attached to the board 21.

However, it is also possible to attach a plurality of parts with a common screw, and it is also possible to collectively attach the heat generating part 25, the second block 26b, and the first block 26a, for example, by the block attachment and detachment screw 31. It is also possible to collectively attach the board 21, the heat generation component 25, the second block 26b, and the first block 26a by the block attachment and detachment screw 31.

Further, a heat transfer sheet or grease for improving the heat transfer properties may be provided between the opposite abutting surfaces 26e and 26f of the cooling block 26.

In the above description, the part of the refrigerant pipe 10 disposed in contact with the cooling block 26 is not necessarily limited to the part 10A between the electronic expansion valve 6 and the indoor heat exchanger 8, and may be other parts of the refrigerant pipe 10 which is kept at a temperature at which the heat generation component 25 provided on the controller 12 can be cooled. For example, the part may be a part between the electronic expansion valve 6 and the outdoor heat exchanger 5. That is, the composite pipe 22 having the pair of tubular portions 10B of the refrigerant pipe 10 and the cooling block 26 can be applied to various parts in the refrigeration cycle 11.

Although the air conditioner 1 has been described as an example of the refrigerating apparatus, the above configuration may be applied to another refrigerating apparatus having a refrigeration cycle.

While preferred embodiments of the invention have been described and illustrated above, it should be understood that these are exemplary of the invention and are not to be considered as limiting. Additions, omissions, substitutions, and other modifications can be made without departing from the spirit or scope of the present invention. Accordingly, the invention is not to be considered as being limited by the foregoing description and is only limited by the scope of the appended claims.

### EXPLANATION OF REFERENCES

1 Air conditioner
2 Compressor
3 Four-way switching valve
4 Outdoor fan
5 Outdoor heat exchanger
6 Electronic expansion valve
7 Indoor fan
8 Indoor heat exchanger
9 Accumulator
10 Refrigerant pipe
10A Part
10B Tubular portion
12 Controller
13 Outdoor unit
14 Board accommodating portion
14a Opening portion
21 Board (circuit board)
21a Front surface
21b Back surface
22 Composite pipe
23 Casing
24 Side surface
25 Heat generation component
26 Cooling block (cooling body)
26a First block (first member)
26a1 Screw portion
26b Second block (second member)
26b1 Through hole
26c Refrigerant pipe attachment surface
26d (26d1, 26d2) Heat generation component attachment surface
26e Opposite abutting surface
26f Opposite abutting surface
26g Positioning protrusion
27 Attaching and detaching through hole
28 Joining portion
29 Bracket
29a Inclined surface
30 Clamping piece
31 Block attachment and detachment screw
31a Head portion
32 Refrigerant pipe attachment and detachment screw

## Claims

1. A refrigerating apparatus comprising:
a casing (23) having a board accommodating portion (14) therein;
a circuit board (21) on which a heat generation component (25) is mounted on a rear surface, the circuit board being attached to the board accommodating portion with a front surface (21a) facing a front side when the casing is installed;
a refrigerant pipe (10) disposed on a rear surface side of the circuit board; and
a cooling body (26) disposed on the rear surface side of the circuit board to come into contact with the refrigerant pipe and the heat generation component,
wherein the cooling body (26) has a first member (26a) attached to the refrigerant pipe (10), a second member (26b) attached to the heat generation component (25), and an attachment and detachment screw (31) capable of attaching and detaching the second member to and from the first member at the front surface side of the circuit board.

2. The refrigerating apparatus according to claim 1, wherein the refrigerant pipe (10) has a joining portion (28) having a contact surface extending obliquely toward a width direction of the casing (23) with respect to the back surface of the circuit board (21), and
the first member (26a) has a refrigerant pipe attachment surface (26c) which is obliquely provided toward the width direction of the casing with respect to the back surface of the circuit board, and an attachment and detachment screw (32) which attaches and detaches the contact surface of the joining portion to and from the refrigerant pipe attachment surface.

3. An assembly method for assembling the cooling body in the refrigerating apparatus according to claim 1 or 2, the assembly method comprising:
attaching the first member (26a) and the second member (26b) by the attachment and detachment screw (31) to form the cooling body (26);
attaching the heat generation component to the second member; and
mounting the heat generation component (25) and the cooling body (26) on the back surface of the circuit board (21).

4. The assembly method according to claim 3, further comprising:
mounting an electronic component on the front surface of the circuit board (21) on which the heat generation component (25) is mounted.

5. A composite pipe (22) comprising:
a refrigerant pipe (10) of a refrigerating apparatus; and
a cooling body (26) which is in contact with the refrigerant pipe and a heat generation component (25) mounted on a circuit board (21) of the refrigerating apparatus,
wherein the cooling body (26) has a first member (26a) attached to the refrigerant pipe (10), a second member (26b) attached to the heat generation component (25), and an attachment and detachment screw (31) capable of attaching and detaching the second member to and from the first member.
